# EUROPEAN PATENT APPLICATION

(11) **EP 1 132 744 A2**
(43) Date of publication of application: **12.09.2001**
(21) Application number: 01104526.7
(22) Date of filing: 02.03.2001
(51) Int. Cl.: G01R 19/25

(54) **Measuring device**

(30) Priority: 09.03.2000 JP 2000064637
(71) Applicant: MITSUBISHI DENKI KABUSHIKI KAISHA, Tokyo 100-8310 (JP)
(72) Inventor: Tokumaru, Susumu, Chiyoda-ku, Tokyo 100-8310 (JP); Kanagawa, Hitoshi, Chiyoda-ku, Tokyo 100-8310 (JP); Tani, Masaki, Chiyoda-ku, Tokyo 100-8310 (JP); Kuwada, Terumi, Mitsubishi Electric Eng. Co., Ltd., Tokyo 100-0004 (JP)
(74) Representative: HOFFMANN - EITLE

(57) **Abstract**

Input to be measured is amplified to arbitrary gain multiplying powers by gain providing means, and analog data for each gain multiplying power is converted into digital data by an A/D converter. The digital data of the arbitrary gain multiplying powers following A/D conversion is recorded in memory means 9, data indicating saturation at the time of A/D conversion is searched from the digital data within the memory in the order of the greatest gain multiplying power, so as to invalidate a series of digital data wherein saturation data exists, and select digital data wherein no saturation data exists.

Thus, at the time of performing A/D conversion and measurement of input to be measured, A/D converter saturation can be eliminated even in the event that measurement input width changes greatly, so appropriate gain multiplication powers can be used and measurement margin of error can be reduced.

## Description

### BACKGROUND OF THE INVENTION

### 1. Field of the invention

The present invention relates to a measuring device which performs measurement of electric current, voltage, electric power, electric energy, and so forth, using an A/D converter.

### 2. Description of the Related Art

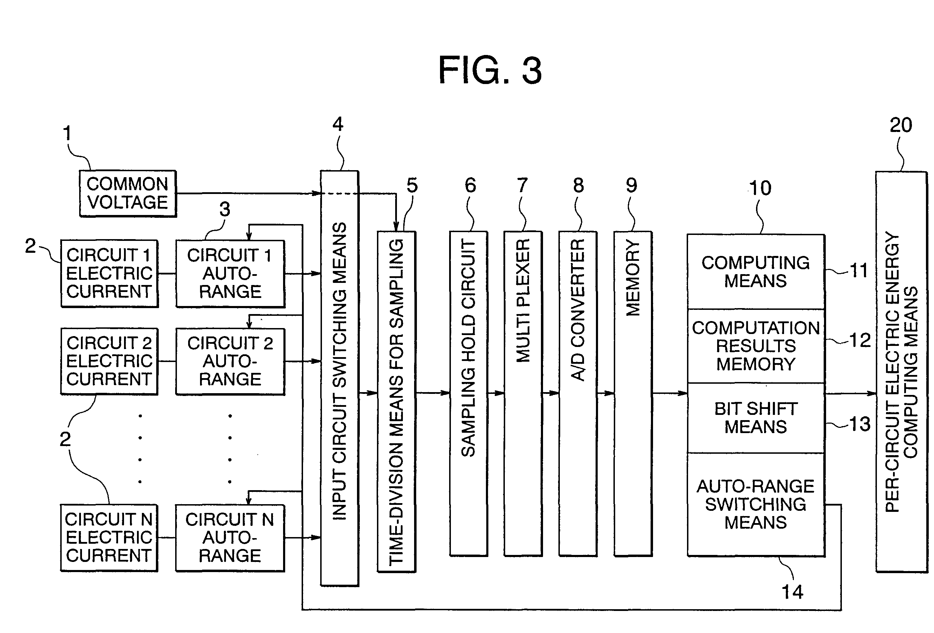

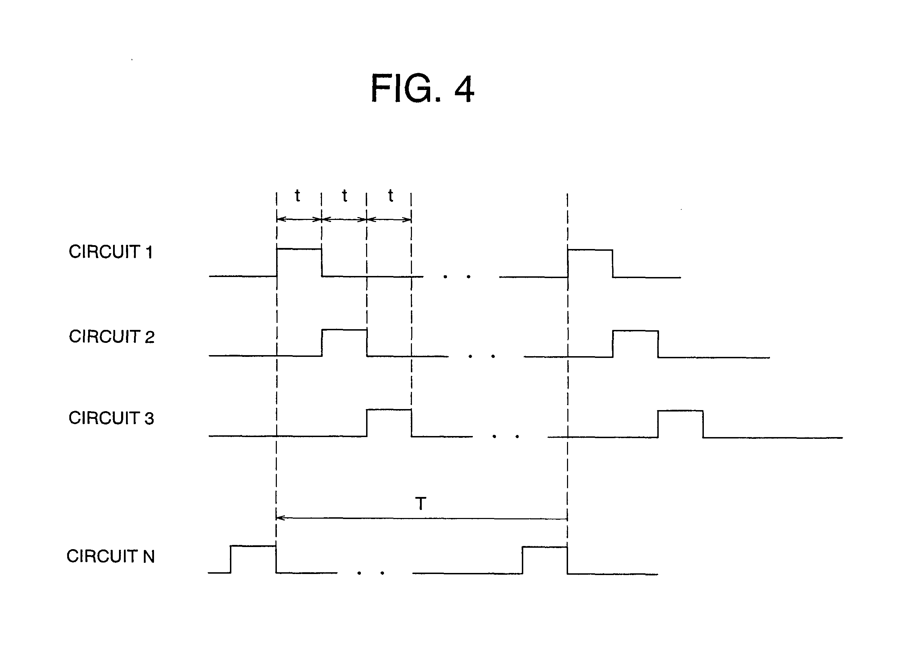

Fig. 3 is a circuit block diagram of a conventional measuring device disclosed in Japanese Unexamined Patent Application Publication No. 10-26641 for example, and Fig. 4 is a diagram for describing the timing for detection of multiple circuit currents.

In the figures, reference numeral 1 denotes voltage detecting means, and 2 denotes electric current detecting means, with each detecting multiple circuit currents. The current detecting means 2 converts the detected currents via transformer into current proportionate voltage signals for sampling. Reference numeral 3 denotes auto-range circuits inserted in the subsequent tier after the voltage detecting means 2, and 4 denotes input circuit switching means for switching over the input of the auto-range circuits 3. Reference numeral 5 denotes time-division means for sampling, 6 denotes a sampling hold circuit, 7 denotes a multiplexer, 8 denotes an A/D converter, 9 denotes memory for storing measured data quantized by the A/D conversion, and 10 denotes time-division electric energy computing means which is made up of computing means 11, computation results memory 12, bit shift means 13, and auto-range switching means 14. Reference numeral 20 denotes per-circuit electric energy computing means for accumulating the electric power computed by the time-division electric energy computing means 10 separately for each circuit.

Next, description will be made regarding the operation of a conventional measuring device.

The input circuit switching means 4 sequentially switches the input from the multiple electric current detecting means 2 as shown in Fig. 4. At this time, from the need to measure the effective value for computation of electric energy, the electric current detection is sequentially switched over in increments (t) of multiples of half-cycles of the AC waveform. Once measurement of the circuits to be measured completes the circle, the measurement returns to the first circuit. Accordingly, the current and voltage measured for each circuit to be measured one time during the time (T) required for one circle is subjected to digital quantizing at the A/D converter 8, and is multiplied by the electric power value by the computing means 11. Interpolation computation is performed for the parts skipped for he sequential switchover measurement by the computation results memory 12 and bit shit means 13, and the results are stored in the per-circuit electric energy computing means 20, thereby obtaining the electric energy for each circuit. The auto-range switching means 14 allows the measurement precision to be maintained at an optimal level by feeding back to the auto-range circuit 3 for the next input level, based on the input level at the electric current detecting means for the part which is being subjected to computation processing.

With conventional measurement devices, gain based on the current computation results are fed back and used for the subsequent measurement. Gain control to the input value is fed back for the subsequent measurement cycle based on the value of the previous measurement cycle data at the auto-range circuit 3, but multiple circuits are being measured sequentially, so time (T) is required for the previous measurement cycle data to make one circle. Accordingly, there is a great chance that the input width being measured will greatly change within this time, so optimal gain control cannot be obtained. This, in the event that the previous input value is small and the current input value is great, excessively great gain to the current input results in saturation of the A/D converter, and conversely, in the event that the previous input value is great and the current input value is small, the gain is too small, meaning that the margin of error in measurement data at the A/D converter increases, which has been a problem.

### SUMMARY OF THE INVENTION

The present invention has been made to solve such problems, and accordingly, it is an object thereof to perform stable gain control for A/D conversion and suppress measurement margin of error to a minimum, even with arrangement wherein multiple circuits are being sequentially measured and in the event that input values rapidly change.

To this end, the measuring device according to the present invention comprises: an A/D converter for performing A/D conversion by sampling of each of analog inputs to be measured which have each been amplified to arbitrary gain multiplying powers by gain providing means; memory means for recording digital data of each of the arbitrary multiplying powers subjected to A/D conversion; and a gain optimal value selecting circuit which searches for data indicating at saturation at the time of the A/D conversion from greatest gain multiplying powers in the digital data recorded in the memory means, invalidating a series of digital data wherein saturation data exists, and selecting digital data wherein no saturation data exists; wherein the measuring device performs computation processing using the selected digital data wherein no saturation data exists.

The present invention may invalidate digital data wherein two or more pieces of saturation data consecutively exist, and may further comprise an input circuit switchover means for inputting a plurality of analog inputs to be measured to the gain providing means, by sequentially switching over the inputs.

### BRIEF DESCRIPTION OF THE DRAWINGS

Fig. 1 is a circuit block diagram of the measuring device according to the present invention;
Figs. 2A through 2E are diagrams describing the relation between the input gain multiplying powers and A/D conversion of the measuring device according to the present invention;
Fig. 3 is a circuit block diagram showing a conventional measuring device; and
Fig. 4 is a diagram describing the timing for detecting multiple circuit electric currents.

### DETAILED DESCRIPTION OF THE PREFERRED EMBODIMENTS

### First Embodiment

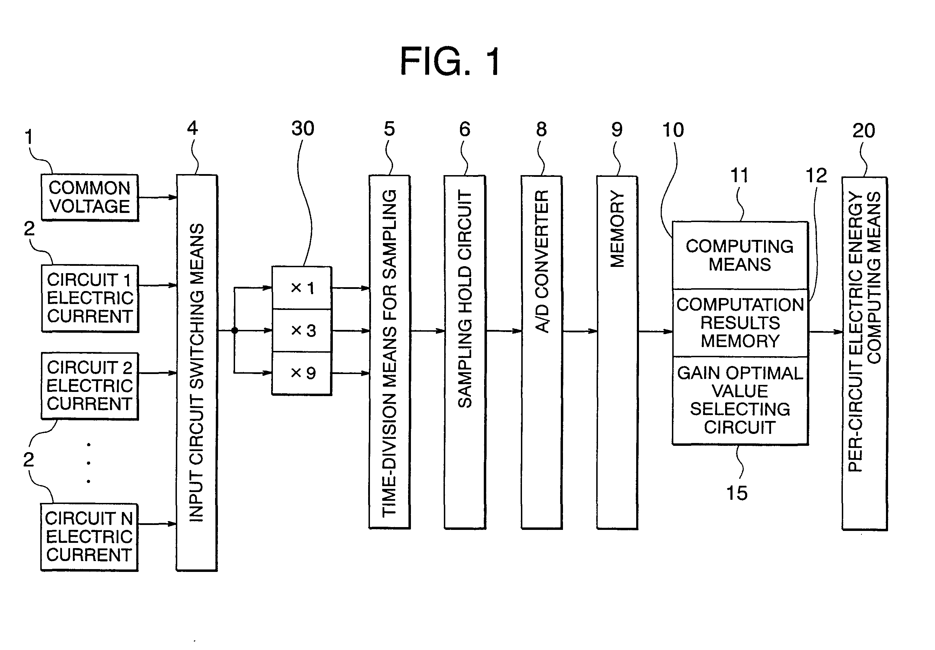

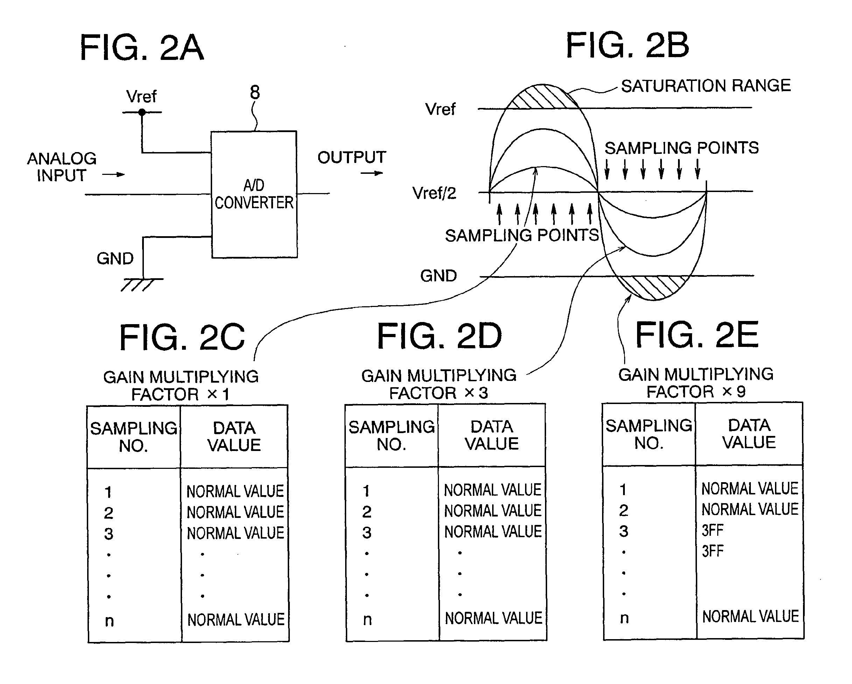

Fig. 1 is a circuit block diagram of a measuring device according to a first embodiment of the present invention, and Figs. 2A through 2E are diagrams describing the relation between the input gain multiplying powers and A/D conversion.

In the figures, the reference numerals which are the same as those of the conventional art shown in Fig. 3 represent components with identical or equivalent functions. Reference numeral 15 denotes a gain optimal value selecting circuit, and 30 denotes a gain providing means, wherein arbitrary gain multiplying powers (e.g., x1, x3, x9) are each multiplied by electric current values detected by the respective electric current detecting means 2.

The following is a description of the operation of the measuring device according to the first embodiment. The electric current values detected by the respective electric current detecting means 2 are sequentially switched, at the input circuit switching over means 4, over in increments of multiples of half-cycles of the AC waveform, so as to obtain effective values, as with the description of the conventional device. The measurement results switched over at the input circuit switching over means 4 are multiplied at the gain providing means 30 by the arbitrary gain multiplying powers (e.g., x1, x3, x9) each. The input signals to which gain multiplying powers have been each multiplied are sampled at the time-division means 5, pass through the sampling hold circuit 6, and converted into digital signals at the A/D converter 8.

The processing of A/D conversion and optimal gain selection will be described with reference to Figs. 2A through 2E. The A/D converter 8 generally has a configuration such as shown in Fig. 2A, and converts the input signal into a digital signal wherein the analog input potential between the reference potential (Vref) and ground potential (GND) has been sampled as shown in Fig. 2B. Now, the same input signal is stored in the memory 13 in the form of a digital data group with differing gain multiplying powers. The digital data group is stored in the memory 13 as conceptually indicated in Figs. 2C through 2E.

In the event that the input signal level exceeds the Vref or GND potential, a saturation phenomena occurs at the A/D converter 8. In the event that the gain multiplying power is too great, this saturation phenomena occurs and measurement cannot be made. Also, in the event that the input signal level is small, resolution deteriorates and measurement precision suffers. An input signal level wherein no saturation phenomena occurs and the signal level is between most all of Vref and GND allows measurement with the highest resolution and best measurement precision. In the event that no saturation phenomena occurs, the data converted into normal values is recorded in the memory 13. In the event that the saturation phenomena occurs, let us say at a 10-bit A/D converter for example, "3FF" which is the maximum hexadecimal code for 10 bits is recorded in the digital data.

Before computation processing, the gain optimal value selecting circuit 15 searches whether or not there is data indicating saturation (i.e., 3FF) from the digital data with the greatest gain multiplying power in the digital data group (i.e., x9), using the digital data recorded to the memory 13. In the event that there is no data indicating saturation (3FF), this digital data is sent to computation processing. In the event that data indicating saturation (3FF) exists consecutively, i.e., two or more in a row, saturation is judged to have occurred, so this series of gain data is excluded from computation, and the flow searches the digital data with the next greatest gain multiplying power (i.e., x3).

Subsequently, computation processing is executed with data thus selected and found to have great gain multiplying power and no data indicating saturation (3FF). In the event that there is only one saturation data in the series of sampling data while searching for the data indicating saturation (3FF), this is ignored, since passing saturation often occurs due to noise, following which restoration processing to a normal value from the previous and following sampling orders is performed and computation processing is carried out, which allows effects of noise to be done away with.

As described above, with the present invention, feedback of gain based on computation results is not used for the next measurement, but rather analog input to be measured is amplified to a plurality of arbitrary gain multiplying powers, and following A/D conversion thereof, data is searched in order from the greatest multiplying powers in the multiplying powers of each and digital data wherein saturation data exists is invalidated, thereby selecting digital data wherein no saturation data exists . Thus, stable gain control can be obtained even in cases wherein input values regarding the A/D conversion rapidly change, and measurement can be carried out with high resolution, so margin in error of measurement can be reduced.

Also, in the event that two or more pieces of saturation data consecutively exist in the series of sampling data, judgment is made that a saturation phenomena has occurred, and in the event that only piece of saturation data exists therein, judgment is made that this is saturation due to passing noise, so restoration processing to a normal value from the previous and following sampling orders is performed, and computation processing is executed, thereby eliminating effects of noise.

Also, the input to be measured is sequentially switched over by the input circuit switchover means and A/D conversion is performed, so multiple circuits can be measured simultaneously. Any given input to be measured is measured at measurement circle time intervals, but in this case, stable gain control and measurement with high resolution can be obtained even in the event that there is sudden change in the input values during measurement intervals.

## Claims

1. A measuring device, comprising:
gain providing means 30 for amplifying analog input to be measured to a plurality of arbitrary gain multiplying powers;
an A/D converter 8 for performing A/D conversion by sampling of the plurality of inputs to be measured which have each been amplified to arbitrary multiplying powers by said gain providing means;
memory means 9 for recording digital data of each of the arbitrary multiplying powers subjected to A/D conversion; and
a gain optimal value selecting circuit 15 which searches for data indicating at saturation at the time of said A/D conversion from greatest multiplying powers in the arbitrary multiplying powers digital data recorded in said memory means, invalidating digital data wherein saturation data exists, and selecting digital data wherein no saturation data exists;
wherein said measuring device performs computation processing using said selected digital data.

2. The measuring device according to Claim 1, which invalidates digital data wherein two or more pieces of saturation data consecutively exist.

3. The measuring device according to either Claim 1 or Claim 2, further comprising an input circuit switching means 4 for inputting a plurality of analog inputs to be measured to said gain providing means, by sequentially switching over said inputs.
